# EUROPEAN PATENT SPECIFICATION

(11) **EP 1 545 011 B1**
(45) Date of publication and mention of the grant of the patent: **09.07.2008**
(21) Application number: 03293191.7
(22) Date of filing: 17.12.2003
(51) Int. Cl.: H03M 13/29, H03M 13/27

(54) **Optimized interleaving of digital signals**
Optimierte Codeverschachtelung digitaler Signale
Entrelacement optimise de signaux numeriques

(43) Date of publication of application: 22.06.2005
(73) Proprietor: Alcatel Lucent, 75008 Paris (FR)
(72) Inventor: Gastaldello, Stefano, 35037 Teolo (Padova) (IT); Macheda, Gianluca, 23880 Casatenovo (Lecco) (IT); Ait Sab, Omar, 91650 Breuillet (FR)
(74) Representative: Menzietti, Domenico

(56) References cited:
- EP-A- 0 437 865
- EP-A- 0 674 395
- EP-A- 1 359 672
- WO-A-02/103956
- DE-A- 10 057 624
- US-A1- 2002 114 358
- INTERNATIONAL TELECOMMUNICATION UNION (ITU): "ITU-T G.975 FORWARD ERROR CORRECTION FOR SUBMARINE SYSTEMS" ITU-T RECOMMENDATION G.975, October 2000 (2000-10), pages 1-24, XP002248444
- YI C ET AL: "Interleaving and decoding scheme for a product code for a mobile data communication" IEEE TRANSACTIONS ON COMMUNICATIONS, IEEE INC. NEW YORK, US, vol. 45, no. 2, 1 February 1997 (1997-02-01), pages 144-147, XP000694661 ISSN: 0090-6778
- AIT SAB O ET AL: "Concatenated forward error correction schemes for long-haul DWDM optical transmission systems" 25TH EUROPEAN CONFERENCE ON OPTICAL COMMUNICATION. (ECOC'99), NICE, FRANCE, vol. II, 26 - 30 September 1999, pages 290-291, XP001035445 ISBN: 2-912328-12-8
- AIT SAB O: "FEC contribution in submarine transmission systems" SUBOPTIC. INTERNATIONAL CONVENTION. THE INTERNATIONAL CONVENTION ON UNDERSEA COMMUNICATIONS, May 2001 (2001-05), pages 496-499, XP001151605

## Description

The present invention relates to an interleaving for coding of digital signals for an optical transport network and in particular concerns two concatenated Reed-Solomon codes and an optimized interleaving.

Coding schemes are used to improve performance of a transmission channel, in order to reduce the bit error rate at a given value of signal to noise ratio, or to have the same bit error rate but at a lower value of the signal to noise ratio. This is achieved at the transmitter side by an encoder which adds some additional bits called redundant bits derived from information bits to those information bits and this introduces an increase of line bit rate. At the receiver side a decoder detects the additional bits which are used to correct erroneous bits.

Two main types of coding schemes are block codes and convolutional codes. A third type, defined as concatenated code, is obtained with a combination of two or more block and/or convolutional codes.

Reed-Solomon (RS) code is a well known block code. In binary codes each symbol carries one bit, while in non binary codes each symbol carries m bits, with m> 1. RS is a non binary code where m=8, so each symbol represents a byte. A data bit stream is divided in blocks of bytes with length K; redundant bytes (also referred as parity bytes) are added so that codeword length is N ( N-K are redundant bytes). The coding ratio is defined as K/N and, multiplied by 100, is an indication of the percentage of information bytes in the code word. The quality of a code is expressed in terms of net coding gain (NCG), defined as the difference between Signal to Noise Ratio (SNR) required without data encoding and SNR required with error correction in order to have a predetermined Bit Error Rate (BER), usually 10*^ (-13). RS is a systematic code: this means that parity bytes are appended after information bytes. It is known in the art that a RS code can detect up to (N-K) erroneous bytes in a block and can locate and correct until (N-K)/2 errored bytes in a block. For example a RS(255,239) is a Reed-Solomon code with N=255 and K=239, which can correct up to 8 erroneous bytes in a single codeword of length 255. The coding ratio is 239/255 = 0.93: this means that about 7% of the code words are used for parity bytes and 93% are information bytes. Modern transmission systems using RS(255,239) achieve a net coding gain of 5.8 dB. One advantage of RS codes is the low complexity of both the encoder and decoder.

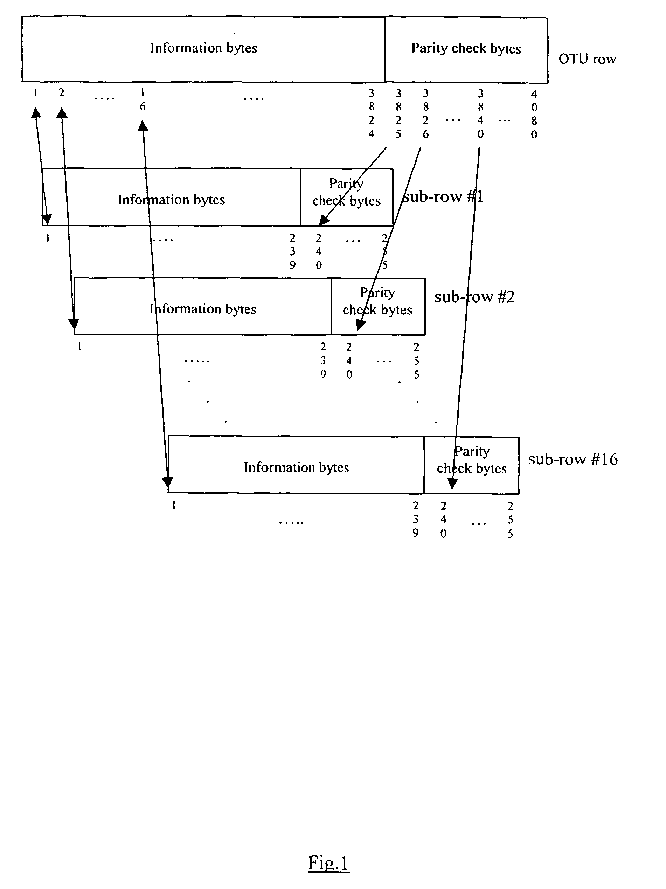

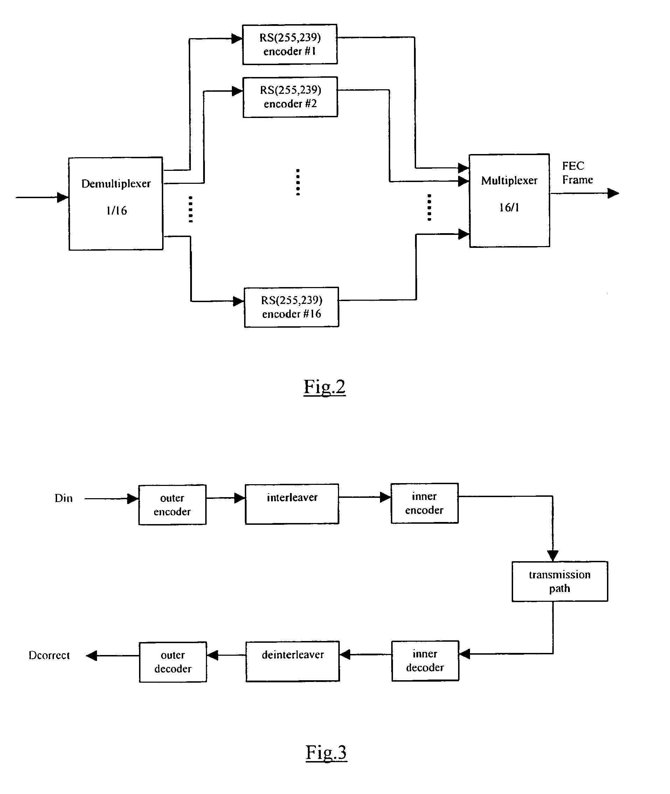

Performance of a block code can be improved with a process called "interleaving". This process consists in a change of the order of bits/bytes before the coding process. In this way burst errors at the receiver are located in different blocks and so the code can correct them. A RS code using interleaving is proposed for the optical channel in ITU-T G.975 (10/2000) for submarine optical transmission systems and proposed in ITU-T G.709/Y.1331 (3/2003) Annex A for terrestrial optical transmission systems, where a forward error correction (FEC) code using a 16-byte interleaved RS(255,239) is proposed. According to ITU-T G.709, an Optical channel Transport Unit (OTU) frame is composed of 4 rows and each row is composed of 4080 bytes. Bytes from 1 to 3824 are information bytes and from 3825 to 4080 are parity checks bytes. Each row is divided in 16 sub-rows using 16 byte-interleaving (this is also called the depth of the interleaving), as shown in Fig. 1. The FEC parity check bytes are calculated over the information bytes 1 to 239 of each sub-row and transmitted in bytes 240 to 255 of the same sub-row. FEC encoder architecture is shown in Fig.2: each of 16 encoders processes a sub-row adding parity bytes and then codewords are multiplexed into a serial data. According to this solution, performance is improved but is not enough for some applications where a high span length is required between two equipments, two optical repeaters or between an equipment and an optical repeater. A possible solution would be to use a better code, with more additional parity bytes to correct more erroneous bytes, but this requires a higher bit rate and a more complex decoder. In fact the quality of high-rate electronics components used by transmitter and receiver drastically decreases when bit rate increases: for this reason FEC schemes having less than 20 % of code overhead should be considered.

One solution is to use concatenated coding schemes which can achieve the same performance as that of a single and powerful error correcting code but with a lower decoding complexity and a smaller increase of line bit rate. Referring to fig. 3, one solution is to concatenate two codes, an outer code and an inner code, with an interleaver between them for the reason explained above. For example at the receiver side the inner code is used to operate at higher BER and the outer code at a low BER, so that outer decoder corrects only remaining errors not corrected by inner decoder. Many concatenated coding schemes solutions have been proposed to improve performance of digital signals transmitted in frames according to ITU-T G.709, expecially to enhance the Immunity of the optical fibre cable system to burst errors. The inner code can be a convolutional one which operates better at higher BER while the outer code can be a block one which operates better at low BER. Alternatevely they can both be block codes, with the inner code with a code ratio higher than the outer code. The overall performance of the system is affected not only by the choice of inner and outer code but also by the choice of a good interleaving, so that errors, expecially burst errors, are located in different blocks. Byte-interleaving, like proposed in ITU-T G.709, is a simple solution but is not enough for critical applications, so a better interleaving is required.

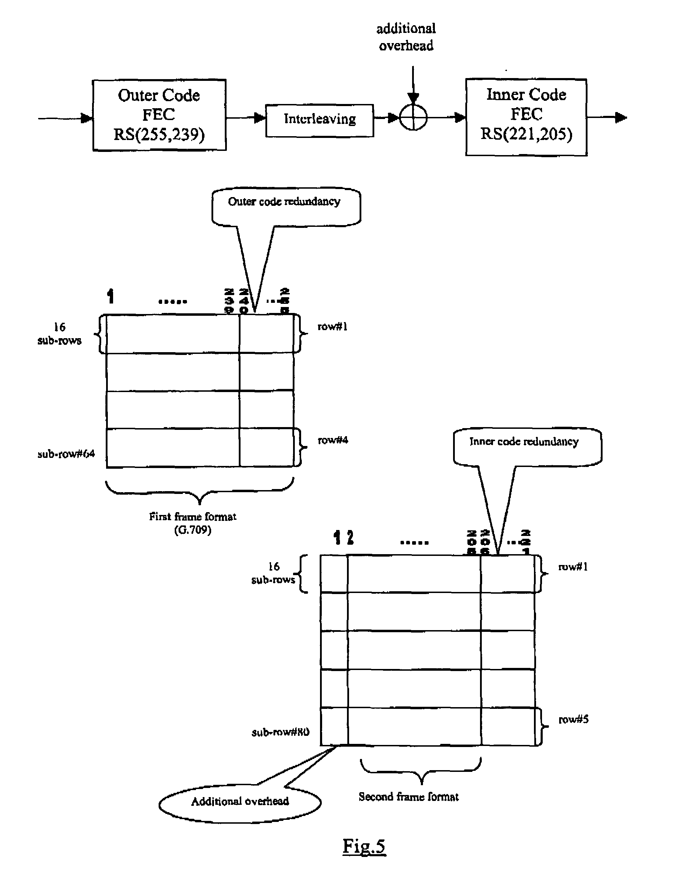

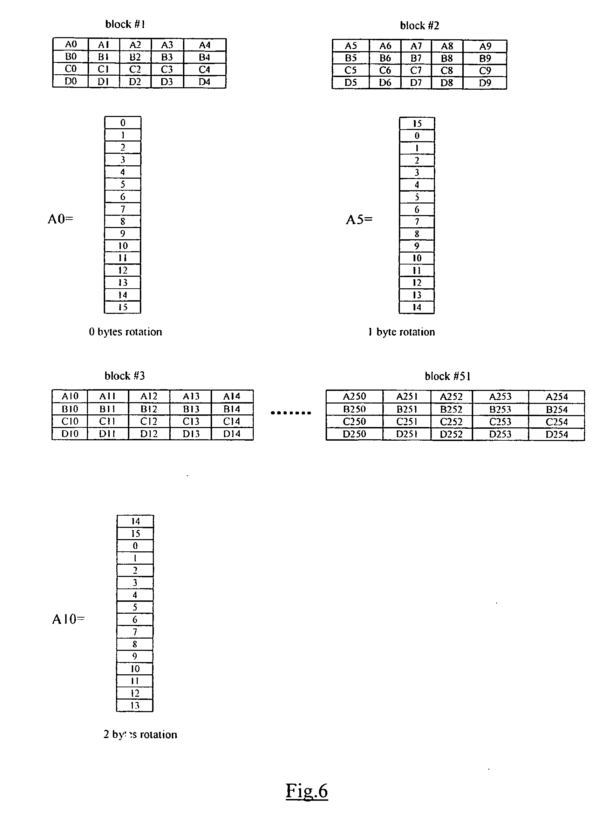

European patent application EP 1359672-A1 discloses an interleaving consisting of shifting downwards cyclically by one position elements (bits) of the columns of a code word matrix of an outer encoding and shows this interleaving in Fig.5 and Fig.6.

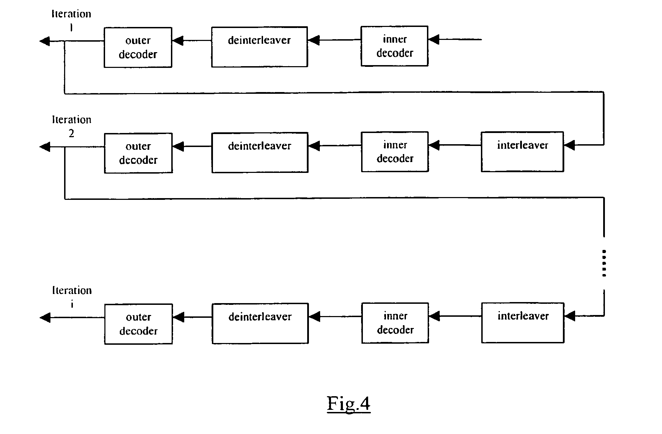

The performance of concatenated codes can also be improved by using an iterative decoding: this technique offers the advantage of improving FEC efficiency without increasing line bit rate. Referring to Fig.4, the first iteration is composed of the previous decoding stage of Fig.3, that is inner decoder, deinterleaver and outer decoder, then decoded data is interleaved again and fed to the inner decoder and the process can be iterated. Usually 2 stages iterative decoding scheme is used, because decoder complexity is greater and code gain is smaller with increasing of the number of the stages.

Many concatenated coding schemes have been proposed with a different net coding gain, depending on the type of codes and of interleaving, to improve performance with respect to the solution proposed in ITU-T G.975, where is proposed a single coding based on RS(255,239) and byte-interleaving for digital signals transmitted in frames compliant to ITU-T G.709. This coding achieves a net coding gain of 5.8 dB with 7% redundancy.

In summary, by implementing coding schemes, the following problems arise:
- a single coding scheme is not enough for some applications,
- a concatenated coding scheme requires the choice of an outer and of an inner code able to locate and correct erroneous bytes minimizing line bit rate,
- a concatenated coding scheme requires the choice of a good interleaving to divide errors in different blocks,
- an iterative decoder in concatenated coding scheme can achieve a further gain code.

In view of the drawbacks and deficiencies of the known and standardized solutions, as described above, the main object of the present invention is to provide an optimized interleaving for coding schemes to improve optical transport network performance. This object is achieved by a method according to claim 1. The method can be used independently of a specific coding scheme, for example also in a general use when a change of the order of bytes in digital signal transmitted in frames is required, i.e. also in wireless applications. The method could be used for both interleaving, i.e. cyclic rotation by +1 byte, and deinterleaving, i.e. cyclic rotation by -1 byte.

A further object is to provide in a concatenated coding scheme a method for changing from a first to a second format of two block codes of different length. This object is achieved by a method according to claim 2.

In a preferred embodiment an overhead for additional user information is inserted in the second frame format.

In summary, by implementing the inventive interleaving, it is possible:
- to achieve the best trade off between coding gain and line bit rate,
- to increase transmission length or capacity or to decrease the cost of the system,
- to offer more overhead channel for customers.

The invention will become fully clear from the following detailed description, given by way of a mere exemplifying and non limiting example, to be read with reference to the attached drawing figures.

Fig.1, 2, 3 and 4 relates to the prior art. Fig.1 shows the OTU row divided in 16 sub-rows for FEC processing, Fig.2 a FEC encoder architecture, Fig.3 a concatenated coding scheme, Fig.4 an iterative decoder.

Fig. 5 shows a schematic example of a concatenated coding scheme using the inventive interleaving. Fig.6 is a schematic illustration of the first and Fig.7 of the second step of the interleaving.

Referring to fig.5, the method is used in a preferred embodiment in a concatenated coding scheme composed of the interleaving and two block codes of different type, the first is a RS(255,239) and the second is a RS(221,205). The outer code operates on each sub-row of the first frame and the inner code on each sub-row of the second frame in the following way. The first frame is compliant to ITU-T G.709 and is composed of 4 rows, each row divided in 16 sub-rows of 255 bytes (like shown in fig.1): columns from 1 until 239 are information bytes and from 240 until 255 are parity bytes of the outer code. The second frame is obtained from the first one using the interleaving and mapping the first frame into the second from column 2 to 205, while column 1 of the second frame is an additional overhead and column 206 until 221 are parity bytes of the inner code, so that the second frame is composed of 5 rows, each row divided in 16 sub-rows of 221 bytes. The number of bytes of the first frame and the number of bytes from column 2 until 205 of the second frame is the same (16320) but with a different format: the first has 4 rows x 16 sub-rows x 255 colums = 16320 bytes, the second from column 2 until 205 has 5 rows x 16 sub-rows x 204 columns =16320 bytes. The task of the interleaving is to rearrange the first frame into the second one from column 2 until 205 in order to change the position of bytes and the format. The inner code requires 205 information bytes: 204 are derived from the first frame and one from the additional overhead.

The first step of the interleaving is shown in fig.6. The first frame is divided in 51 blocks, each block is composed of words arranged in 4 rows and 5 columns, each word is composed of 16 bytes arranged in a column, each byte is composed of 8 bits arranged in a row. The 4 rows of blocks in fig.6 corresponds to each of the 4 rows of the first frame of fig.5, word A0 of fig.6 corresponds to the first column of row 1 of fig.5. In the first step the structure of the frame is unchanged (each block is still composed of 4 rows and 5 columns) while the position of the bytes in the word of each block is changed according to a cyclic rotation from block to block: in the first block bytes of each word are unchanged, in the second block bytes of each word are rotated by one like shown in word A5, in the third block bytes of each word are rotated by two like shown in word A 10, and this rotation is repeated until block 16 where word A75 (not shown in fig.6) is rotated by 15 bytes. Now the process is iterated in the same way from block 17, where word A80 (not shown in fig.6) has the same value as word A0, until the last block 51. Each word of each block, for example word B0, follows this rule.

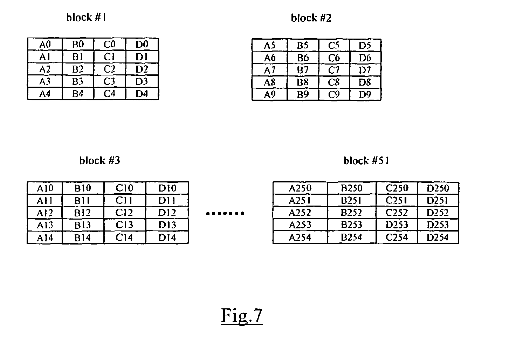

The second step of the interleaving is shown in fig.7. Each block is now composed of 5 rows and 4 columns. The 5 rows of blocks in fig.7 corresponds to each of the 5 rows of the first frame of fig.5 from column 2 until 205, word A0 of fig.7 corresponds to the second column of row 1 of fig.5. In this step the position of bytes in the words is unchanged while the structure of the frame is changed according to the following rule: words of the first column of the first block of the first frame format (fig.6) are read and written in the first row of the first block of the second frame format (fig.7), words of the first column of the second block of the first frame format (fig.6) are read and written in the first row of the second block of the second frame format (fig.7), repeating this read-write process in order to read the first columns of each block of the first frame format and write the first row of each block of the second frame format. This process is iterated, reading the words of the second column of each block of the first frame format and writing the second row of each block of the second frame format. In the same way are written rows 3, 4 and 5 of the second frame format.

According to this preferred implementation of the interleaving and of the two concatenated block codes, it is possibile to achieve a coding gain of about 8.2 dB with 2 steps iterative decoding. The overall redundancy of the concatenated code is 16.5 %.

The inventive method can be used in different configurations. For example the change of the order of bytes can be a rotation of two bytes from two subsequent blocks, or rotation of one byte from two non subsequent blocks. The change of format can follow a process different from the explained above, for example reading of the first column of non subsequent blocks of the first frame format: the only constraint is that it is necessary to read a number of words in blocks of the first frame format equal to the number of words in each row of the second frame format.

This method can be advantageously implemented on a network element, for example an Add-Drop Multiplexer (ADM), including hardware means like an Application Specific Integrated Circuit (ASIC), Field Programmable Gate Array (FPGA), microprocessor or memories to perform concatenated coding; these means include for example a transmitter and a receiver, wherein the transmitter is a series connection of a first encoder for outer coding, an interleaver to perform all the steps of the method and a second encoder for inner coding, while the receiver in a preferred embodiment is a 2 steps decoder, in the first step including a series connection of a first decoder for inner decoding, a first deinterleaver and a second decoder for outer decoding, and in the second step including a series connection of an interleaver, a third decoder for inner decoding, a second deinterleaver and a fourth decoder for outer decoding. Memories, usually Random Access Memories (RAM), are required for storing information of the first and second frame format and to perform read and write operations for cyclic rotation and change of the frame format. The method is implemented in a preferred embodiment through or together with a software program like Very high speed integrated circuit Hardware Description Language (VHDL) or C language, by one or more VHDL processes or C routines. The network element thus includes for example for encoding and interleaving digital signals to be transmitted a first software process for outer encoding, a second software process for interleaving and a third software process for inner encoding; for decoding and deinterleaving received digital signals a fourth software process for inner decoding, a fifth software process for deinterleaving and a sixth software process for outer decoding. The network element advantageously also includes for encoding and interleaving digital signals to be transmitted a seventh software process for demultiplexing a serial digital signal in at least two parallel digital signals, an eighth software process for multiplexing at least two parallel digital signals into a serial digital signal and for each of the parallel digital signals an encoding process according to the first, the second and the third process; for decoding and deinterleaving received digital signals a ninth software process for demultiplexing a serial digital signal in at least two parallel digital signals, a tenth software process for multiplexing at least two parallel digital signals into a serial digital signal and for each of the parallel digital signals a decoding process according to the fourth, fifth and sixth process. Finally the network element advantageously includes for decoding and deinterleaving received digital signals an eleventh software process for interleaving, this software process being performed after the sixth software process, performing the fourth, fifth and sixth process another time after the eleventh process and iterating the eleventh, fourth, fifth and sixth process at least one time in order to have the decoded signal from the last iterated sixth process.

## Claims

1. Method for changing the order of bytes of digital signals transmitted in frames, each frame including blocks (#1, #2,... #51), each block including words (A0. A5. A10,..), each word including bytes (0, 1,...15), the words being arranged in rows and columns, by rearranging the words of a first frame format into a second frame format, the number of rows and columns being different for the first and second frame format, the arrangement comprising the step of:
e) changing the position of the bytes in at least part of the words of the first frame format according to a rule, wherein the rule determines, from block to block, a cyclic rotation of the bytes;
**characterized by** further including the steps of:
f) reading from at least two blocks of the first frame format a number of words (A0 B0 C0 D0, A5 B5 C5 D5, ...) corresponding to the number of words of the first row of the second frame format and writing them into the first row of at least two blocks of the second frame format:
g) reading from at least two blocks of the first frame format a number of words (A1 B1 C1 D1, A6 B6 C6 D6. ..) corresponding to the number of words of the second row of the second frame format and writing them into the second row of at least two blocks of the second frame format;
h) reading from at least two blocks of the first frame format further numbers of words, each number corresponding to the number of words in further rows of the second frame format and writing them subsequently from the third to the last row of at least two blocks of the second frame format.

2. Method according to claim 1, wherein:
- step b) includes reading subsequently the words of the first column of each block (A0 B0 C0 D0, A5 B5 C5 D5, ...) of the first frame format and writing them into the first row of each block of the second frame format;
- step c) includes reading subsequently the words of the second column of each block (A1 B1 C1 D1, A6 B6 C6 D6, ..) of the first frame format and writing them into the second row of each block of the second frame format,
- step d) includes reading subsequently the words until the last column of each block of the first frame format and writing them until the last row of each block of the second frame format.

3. Method according to claim 1, **characterized in that** the words (A0, A5, A10,..) are arranged in columns of bytes (0, 1,...15).

4. Method according to any of the previous claims, wherein the method for changing the order of bytes is used in a concatenated coding including an outer encoding and an inner encoding, the method further including the steps of performing the outer encoding before the arrangement and the inner encoding after the arrangement.

5. Method according to claim 4, further including the step of adding an overhead to the second frame format for carrying additional user information.

6. Interleaver including hardware and/or software means adapted to perform all the steps of the method according to any of claims 1 to 4.

7. Network element including hardware means adapted to perform concatenated coding, said means including a transmitter, the transmitter including a series connection of a first encoder for outer coding, an interleaver adapted to perform all the steps of the method according to any of claims 1 to 3 and a second encoder for inner coding.

8. Network element according to claim 7, further including a receiver, the receiver including a series connection of a first decoder for inner decoding, a deinterleaver adapted to perform all the steps of the method according to any of claims 1 to 3 and a second decoder for outer decoding.

9. Network element according to claim 8, wherein the transmitter further includes an adder between the interleaver and the second encoder to add an overhead for additional user information and the receiver further includes a subtractor between the first decoder and the deinterleaver to subtract the overhead of the additional user information.

10. Software program comprising software program code means adapted to perform all the steps of the method according to any of claims 1 to 3 when said program is run on hardware.

## Patentansprüche

1. Verfahren zur Änderung der Reihenfolge von Bytes von digitalen Signalen, die in Rahmen übertragen werden, wobei jeder Rahmen Blöcke enthält (#1, #2,...#51), wobei jeder Block Wörter enthält (A0, A5, A10,...), wobei jedes Wort Bytes enthält (0, 1,...15), wobei die Wörter in Zeilen und Spalten angeordnet sind, durch Neuanordnen der Wörter eines ersten Rahmenformats in einem zweiten Rahmenformat, wobei die Anzahl der Zeilen und Spalten für den ersten und den zweiten Rahmen verschieden ist, wobei das Neuanordnen folgende Schritte umfasst:
e) Ändern der Position der Bytes in mindestens einem Teil der Wörter des ersten Rahmenformats entsprechend einer Regel, wobei die Regel von Block zu Block eine zyklische Drehung der Bytes bestimmt;
**dadurch gekennzeichnet, dass** es weiterhin folgende Schritte umfasst:
f) Lesen aus mindestens zwei Blöcken des ersten Rahmenformats einer Anzahl von Wörtern (A0 B0 C0 D0, A5 B5 C5 D5,...), welche der Anzahl von Wörtern der ersten Zeile des zweiten Rahmenformats entspricht, und Schreiben dieser Wörter in die erste Zeile von mindestens zwei Blöcken des zweiten Rahmenformats;
g) Lesen aus mindestens zwei Blöcken des ersten Rahmenformats einer Anzahl von Wörtern (A1 B1 C1 D1, A6 B6 C6 D6,...), welche der Anzahl von Wörtern der zweiten Zeile des zweiten Rahmenformats entspricht, und Schreiben dieser Wörter in die zweite Zeile von mindestens zwei Blöcken des zweiten Rahmenformats;
h) Lesen aus mindestens zwei Blöcken des ersten Rahmenformats von weiteren Anzahlen von Wörtern, wobei jede Anzahl der Anzahl von Wörtern in weiteren Zeilen des zweiten Rahmenformats entspricht, und anschließendes Schreiben dieser Wörter von der dritten bis in die letzte Zeile von mindestens zwei Blöcken des zweiten Rahmenformats.

2. Verfahren nach Anspruch 1, wobei
- Schritt b) das anschließende Lesen der Wörter der ersten Spalte jedes Blocks (A0 B0 C0 D0, A5 B5 C5 D5,...) des ersten Rahmenformats und das Schreiben dieser Wörter in die erste Zeile eines jeden Blocks des zweiten Rahmenformats umfasst;
- Schritt c) das anschließende Lesen der Wörter der zweiten Spalte eines jeden Blocks (A1 B1 C1 D1, A6 B6 C6 D6,...) des ersten Rahmenformats und das Schreiben dieser Wörter in die zweite Zeile eines jeden Blocks des zweiten Rahmenformats umfasst;
- Schritt d) das anschließende Lesen der Wörter bis in die letzte Spalte eines jeden Blocks des ersten Rahmenformats und das Schreiben dieser Wörter bis in die letzte Zeile eines jeden Blocks des zweiten Rahmenformats umfasst.

3. Verfahren nach Anspruch 1, **dadurch gekennzeichnet, dass** die Wörter (A0, A5, A10,..) in Bytespalten (0, 1,...15) angeordnet sind.

4. Verfahren nach einem beliebigen der vorstehenden Ansprüche, wobei das Verfahren zur Änderung der Reihenfolge von Bytes in einer verketteten Codierung, welche eine äußere Codierung und eine innere Codierung umfasst, angewendet wird, wobei das Verfahren weiterhin die Schritte des Ausführens der äußeren Codierung vor dem Anordnen und der inneren Codierung nach der Anordnung umfasst.

5. Verfahren nach Anspruch 4, weiterhin umfassend den Schritt des Hinzufügens von Verwaltungsdaten zum zweiten Rahmenformat, um zusätzliche Nutzerdaten zu übertragen.

6. Verschachteler mit Hardware- und/oder Software-Mitteln, welcher fähig ist, alle Schritte des Verfahrens nach einem beliebigen der Ansprüche 1 bis 4 auszuführen.

7. Netzelement mit Hardware-Mitteln, welches fähig ist, eine verkettete Codierung durchzuführen, wobei die besagten Mittel einen Sender umfassen, welcher eine Reihenschaltung eines ersten Codierers für das äußere Codieren, einen Verschachteler zum Ausführen aller Schritte des Verfahrens nach einem beliebigen der Ansprüche 1 bis 3 und einen zweiten Codierer für das innere Codieren umfasst.

8. Netzelement nach Anspruch 7, weiterhin umfassend einen Empfänger, welcher eine Reihenschaltung eines ersten Decodierers für das innere Decodieren, einen Entschachteler zum Ausführen aller Schritte des Verfahrens nach einem beliebigen der Ansprüche 1 bis 3 und einen zweiten Decodierer für das äußere Decodieren umfasst.

9. Netzelement nach Anspruch 8, wobei der Sender weiterhin einen Addierer zwischen dem Verschachteler und dem zweiten Codierer zum Hinzufügen von Verwaltungsdaten für zusätzliche Nutzerdaten umfasst, und der Empfänger weiterhin einen Subtrahierer zwischen dem ersten Decoder und dem Entschachteler zum Subtrahieren der Verwaltungsdaten der zusätzlichen Nutzerdaten umfasst.

10. Softwareprogramm mit Software-Programmcode-Mitteln, welche fähig sind, alle Schritte des Verfahrens nach einem beliebigen der Ansprüche 1 bis 3 auszuführen, wenn das besagte Programm auf der Hardware läuft.

## Revendications

1. Procédé de changement de l'ordre des octets de signaux numériques transmis dans des trames, chaque trame comprenant des blocs (#1, #2, ..., #51), chaque bloc comprenant des mots (A0, A5, A10, ...), chaque mot comprenant des octets (0, 1, ..., 15), les mots étant disposés en rangées et colonnes, en réagençant les mots d'un premier format de trame en un second format de trame, le nombre de rangées et de colonnes étant différent pour les premier et second formats de trame, l'agencement comprenant l'étape suivante :
e) changement de la position des octets dans au moins une partie des mots du premier format de trame en fonction d'une règle, dans lequel la règle détermine, d'un bloc à l'autre, une rotation cyclique des octets ;
**caractérisé en outre par** les étapes suivantes :
f) lecture dans au moins deux blocs du premier format de trame d'un certain nombre de mots (A0 B0 C0 D0, A5 B5 C5 D5, ...) correspondant au nombre de mots de la première rangée du second format de trame et écriture de ceux-ci dans la première rangée d'au moins deux blocs du second format de trame ;
g) lecture dans au moins deux blocs du premier format de trame d'un certain nombre de mots (A1 B1 C1 D1, A6 B6 C6 D6, ...) correspondant au nombre de mots de la seconde rangée du second format de trame et écriture de ceux-ci dans la seconde rangée d'au moins deux blocs du second format de trame ;
h) lecture dans au moins deux blocs du premier format de trame d'un certain nombre de mots supplémentaires, chaque nombre correspondant au nombre de mots dans des rangées supplémentaires du second format de trame et ensuite écriture de ceux-ci de la troisième à la dernière rangée d'au moins deux blocs du second format de trame.

2. Procédé selon la revendication 1, dans lequel :
l'étape b) comprend ensuite la lecture des mots de la première colonne de chaque bloc (A0 B0 C0 D0, A5 B5 C5 D5, ...) du premier format de trame et l'écriture de ceux-ci dans la première rangée de chaque bloc du second format de trame ;
l'étape c) comprend ensuite la lecture des mots de la seconde colonne de chaque bloc (A1 B1 C1 D1, A6 B6 C6 D6, ...) du premier format de trame et l'écriture de ceux-ci dans la seconde rangée de chaque bloc du second format de trame ;
l'étape d) comprend ensuite la lecture des mots jusqu'à la dernière colonne de chaque bloc du premier format de trame et l'écriture de ceux-ci jusqu'à la dernière rangée de chaque bloc du second format de trame.

3. Procédé selon la revendication 1, **caractérisé en ce que** les mots (A0, A5, A10, ...) sont disposés en colonnes d'octets (0, 1, ..., 15).

4. Procédé selon l'une quelconque des revendications précédentes, dans lequel le procédé de changement de l'ordre des octets est utilisé en codage concaténé comprenant un codage externe et un codage interne, le procédé comprenant en outre les étapes d'exécution du codage externe avant l'agencement et du codage interne après l'agencement.

5. Procédé selon la revendication 4, comprenant en outre l'étape d'ajout d'un surdébit au second format de trame afin de transporter des informations utilisateur supplémentaires.

6. Dispositif d'entrelacement comprenant des moyens matériels et/ou logiciels adaptés pour exécuter toutes les étapes du procédé selon l'une quelconque des revendications 1 à 4.

7. Élément de réseau comprenant des moyens matériels adaptés pour exécuter un codage concaténé, lesdits moyens comprenant un émetteur, l'émetteur comprenant une connexion en série d'un premier codeur pour le codage externe, un dispositif d'entrelacement adapté pour exécuter toutes les étapes du procédé selon l'une quelconque des revendications 1 à 3 et un second codeur pour le codage interne.

8. Élément de réseau selon la revendication 7, comprenant en outre un récepteur, le récepteur comprenant une connexion en série d'un premier décodeur pour le décodage interne, un dispositif de désentrelacement adapté pour exécuter toutes les étapes du procédé selon l'une quelconque des revendications 1 à 3 et un second décodeur pour le décodage externe.

9. Élément de réseau selon la revendication 8, dans lequel l'émetteur comprend en outre un additionneur entre le dispositif d'entrelacement et le second codeur qui ajoute un surdébit pour des informations utilisateur supplémentaires et le récepteur comprend en outre un soustracteur entre le premier décodeur et le dispositif de désentrelacement qui soustrait le surdébit d'informations utilisateur supplémentaires.

10. Programme logiciel comprenant un moyen de codage de programme logiciel adapté pour exécuter toutes les étapes du procédé selon l'une quelconque des revendications 1 à 3 lorsque ledit programme est exécuté sur un moyen matériel.
